# FASCICULE DE BREVET EUROPEEN

(11) **EP 2 224 588 B1**
(45) Date de publication et mention de la délivrance du brevet: **14.10.2015**
(21) Numéro de dépôt: 10154748.7
(22) Date de dépôt: 25.02.2010
(51) Int. Cl.: H03B 5/30

(54) **Oscillateur à base de séries de quatre nanofils**
Oszillator auf Basis von Reihen aus vier Nanodrähten
Oscillator based on series of four nanowires

(30) Priorité: 27.02.2009 FR 0900905
(43) Date de publication de la demande: 01.09.2010
(73) Titulaire: Commissariat à l'Énergie Atomique et aux Énergies Alternatives, 75015 Paris (FR)
(72) Inventeur: Colinet, Eric, 38240 Meylan (FR); Duraffourg, Laurent, 38500, Voiron (FR)
(74) Mandataire: de Jong, Jean Jacques

(56) Documents cités:
- WO-A-2007/036820
- WO-A1-2006/067757
- FENG X L ET AL: "Phase Noise and Frequency Stability of Very-High Frequency Silicon Nanowire Nanomechanical Resonators" SOLID-STATE SENSORS, ACTUATORS AND MICROSYSTEMS CONFERENCE, 2007. TRANSDUCERS 2007. INTERNATIONAL, IEEE, PISCATAWAY, NJ, USA, 10 juin 2007 (2007-06-10), pages 327-330, XP031216034 ISBN: 978-1-4244-0841-2
- SHEEHAN ET AL: "Intrinsically biased, resonant NEMS-MEMS oscillator and the second law of thermodynamics" PHYSICA E - LOW-DIMENSIONAL SYSTEMS AND NANOSTRUCTURES, ELSEVIER SCIENCE BV, NL, vol. 29, no. 1-2, 1 octobre 2005 (2005-10-01), pages 87-99, XP005096390 ISSN: 1386-9477
- RONGRUI HE ET AL: "Self-Transducing Silicon Nanowire Electromechanical Systems at Room Temperature" NANO LETTERS, ACS, WASHINGTON, DC, US, vol. 8, no. 6, 1 janvier 2008 (2008-01-01) , pages 1756-1761, XP007910016 ISSN: 1530-6984 [extrait le 2008-05-16]
- TORIYAMA T ET AL: "Single crystal silicon piezoresistive nano-wire bridge" SENSORS AND ACTUATORS A, ELSEVIER SEQUOIA S.A., LAUSANNE, CH, vol. 108, no. 1-3, 15 novembre 2003 (2003-11-15), pages 244-249, XP004475555 ISSN: 0924-4247

## Description

### Domaine technique de l'invention

L'invention est relative à un oscillateur comportant au moins un résonateur électromécanique, des moyens d'excitation du résonateur et des moyens de détection du mouvement du résonateur.

### État de la technique

Afin de pourvoir continuer la course à la miniaturisation, les circuits microélectroniques doivent intégrer de nouvelles fonctions tout en minimisant la surface des circuits. Un des principaux domaines d'étude est l'intégration de dispositifs résonnants à l'intérieur des puces. En effet, dans de nombreux domaines, tels que les capteurs chimiques en phase gazeuse, les capteurs de force moléculaire ou encore les spectromètres de masse, il est intéressant que le circuit intégré comporte au moins un oscillateur. Les concepteurs travaillent à remplacer l'oscillateur qui est un composant discret supplémentaire par un oscillateur intégré. En intégrant cet oscillateur, on peut alors espérer, en plus du gain en surface ou en volume du dispositif, un gain en énergie consommée et une amélioration des performances.

De nombreuses publications traitent de résonateurs électromécaniques de taille micrométrique ou nanométrique, c'est-à-dire des résonateurs ayant des dimensions compatibles avec celles des circuits intégrés. Cependant, si l'obtention du résonateur à une taille raisonnable est un point important, il est nécessaire que la partie électronique qui lui est associée, afin de transformer un résonateur en un oscillateur, soit également compatible avec le cahier des charges très strict du circuit intégré, ce qui est actuellement très difficile.

Le document WO 2007/036 820 décrit un tel oscillateur basé sur un résonateur piézorésistif.

### Objet de l'invention

L'invention à pour objet l'obtention d'un oscillateur qui soit extrêmement compact et qui soit facile à mettre en oeuvre.

L'oscillateur selon l'invention est caractérisé par les revendications annexées et plus particulièrement par le fait qu'il comporte au moins une première série d'un multiple de quatre sous-ensembles comportant chacun une borne d'excitation et une borne de sortie, les sous-ensembles étant montés en série en boucle fermée, la borne de sortie de chaque sous-ensemble étant connectée à la borne d'excitation du sous-ensemble suivant, l'oscillateur comportant une borne de sortie constituée par une borne de sortie d'un des sous-ensembles, chaque sous-ensemble comportant les moyens d'excitation et au moins un nanofil constituant le résonateur électromécanique, une première borne du nanofil étant connectée à une première tension d'alimentation, une seconde borne du nanofil constituant la borne de sortie, une borne d'entrée des moyens d'excitation constituant la borne d'excitation du sous-ensemble, la borne de sortie de chaque sous-ensemble est connectée à la masse par l'intermédiaire d'un circuit résistif correspondant.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente un premier mode de réalisation d'un oscillateur selon l'invention,
- la figure 2 représente un second mode de réalisation d'un oscillateur selon l'invention,
- la figure 3 représente un troisième mode de réalisation d'un oscillateur selon l'invention,
- les figures 4 et 5 représentent un quatrième mode de réalisation d'un oscillateur selon l'invention.

### Description d'un mode préférentiel de l'invention

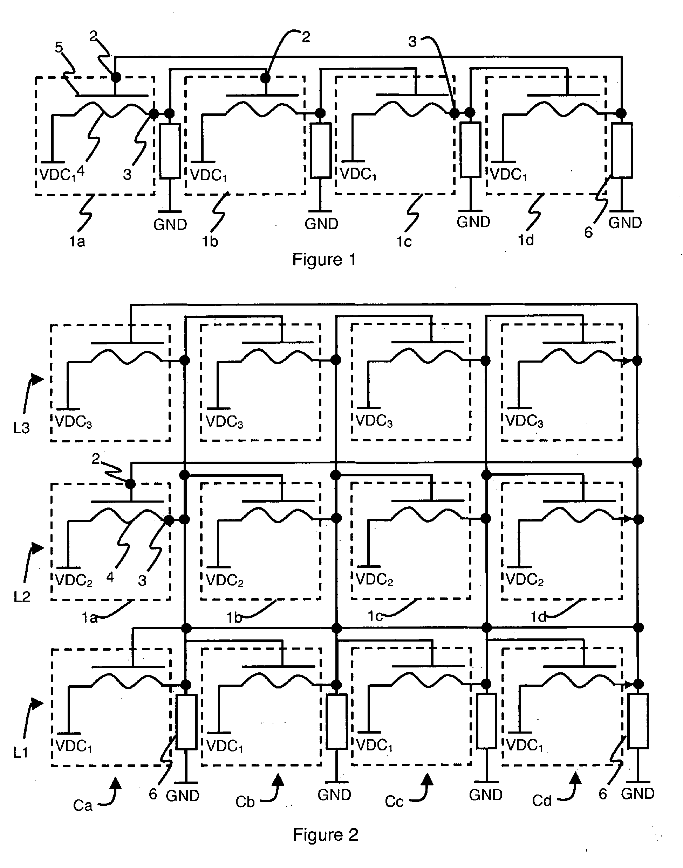

Comme illustré à la figure 1, l'oscillateur comporte une première série de quatre sous-ensembles 1 (1a, 1b, 1c et 1d) qui sont montés ensemble en série pour former une boucle fermée. Chaque sous-ensemble 1 de la première série comporte des bornes d'excitation 2 et de sortie 3 et est connecté à deux autres sous-ensembles 1 adjacents. Si l'on considère que la première série comporte des premier 1a, second 1b, troisième 1c et quatrième 1 d sous-ensembles, le second sous-ensemble 1 b est connecté au premier 1a et au troisième 1c sous-ensembles. Le troisième sous-ensemble 1c est également connecté au quatrième sous-ensemble 1d qui est lui-même connecté au premier sous-ensemble 1a.

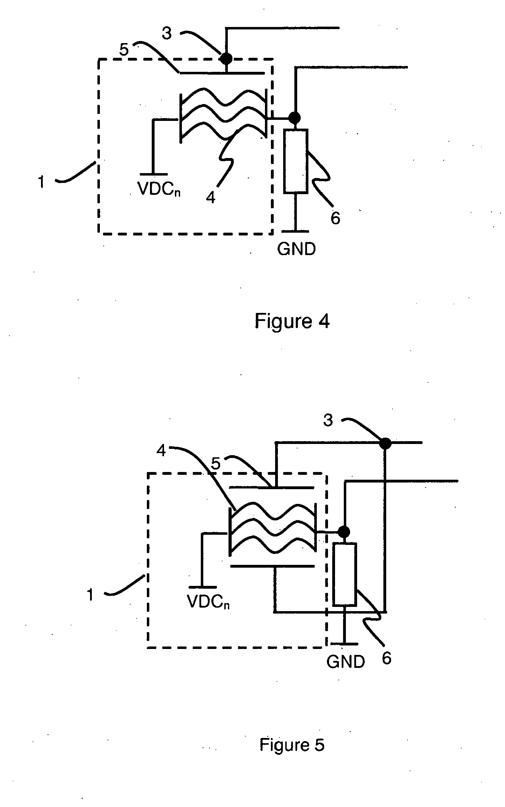

Chaque sous-ensemble 1 comporte un résonateur 4, des moyens 5 d'excitation du résonateur et des moyens de détection du mouvement du résonateur. Dans chaque sous-ensemble 1, un nanofil 4 constitue un résonateur électromécanique. Le mouvement du nanofil 4 est converti en un signal électrique représentatif par un moyen de transduction adapté constitué par les moyens de détection du sous-ensemble. Avantageusement, les moyens de détection sont de type piézorésistif et sont réalisés directement par le nanofil 4 qui présente un effet piézorésistif géant comme cela est décrit dans l'article de He et al. (« Giant piezoresistance effect in silicon nanowires » nature nanotechnology, vol. 1, October 2006, pp42-46). Chaque sous-ensemble 1 comporte donc des moyens 5 d'excitation du nanofil 4. Chaque sous-ensemble comporte au moins un nanofil, c'est-à-dire un nanofil comme dans les modes de réalisations illustrés aux figures 1 à 3, ou une pluralité de nanofils comme dans les modes de réalisation illustrés aux figures 4 et 5.

Dans chaque sous-ensemble 1 de la première série, une première borne du nanofil 4 est connectée à une première tension d'alimentation (VDC₁), une deuxième borne du nanofil 4 constitue la borne de sortie 3 du sous-ensemble 1. Une borne d'entrée des moyens 5 d'excitation constitue la borne d'excitation 2 du sous-ensemble 1. La borne de sortie 3 de chaque sous-ensemble 1 est connectée à la masse GND par l'intermédiaire d'un circuit résistif 6 correspondant.

Pour former une boucle fermée, la borne de sortie 3 de chaque sous-ensemble 1 est connectée à la borne d'excitation 2 du sous-ensemble 1 suivant. Ainsi, on considère que le sens de transit des données dans un sous-ensemble 1 est depuis une borne d'excitation 2 vers une borne de sortie 3. L'oscillateur comporte une borne de sortie qui est constituée par la borne de sortie 3 d'un des sous-ensembles 1. L'oscillateur comporte également une borne d'entrée qui est constituée par la borne d'excitation 2 du sous-ensemble qui suit le sous-ensemble comportant la borne de sortie de l'oscillateur.

Le circuit résistif 6 peut être formé par une résistance, un transistor à effet de champ ou bipolaire, un pont résistif ou tout autre élément capable de convertir une variation de courant en une variation de tension.

A titre d'exemple, si la borne de sortie du signal représentatif de l'oscillateur est constituée par la borne de sortie 3 du quatrième sous-ensemble 1d, la borne d'entrée d'un signal électrique dans l'oscillateur est constituée par la borne d'excitation 2 du premier sous-ensemble 1a.

De cette manière, chaque sous-ensemble 1 transmet un signal représentatif du mouvement de son nanofil 4 sur les moyens d'excitation 5 du sous-ensemble 1 suivant ce qui commande l'actionnement du nanofil 4 suivant. La tension aux bornes du circuit résistif 6 associé à la borne de sortie de l'oscillateur, ici le circuit résistif 6 associé au quatrième sous-ensemble 1d, est représentative du courant délivré par le quatrième nanofil 4. Le signal émis par les moyens de détection est converti en une tension au moyen du circuit résistif 6 pour générer une force d'actionnement sur le nanofil 4 suivant et ainsi remplir les conditions d'oscillation.

La dynamique des quatre nanofils 4 de la première série permet de remplir la condition de phase nécessaire à l'obtention d'un oscillateur sans qu'un élément déphaseur externe ne soit ajouté. D'autre part, l'effet piézorésistif géant observé dans les nanofils permet d'atteindre des valeurs de gain nécessaires à la mise en oscillation. Chaque sous-ensemble réalisant un déphasage à 90°, l'utilisation d'une première série de quatre sous-ensembles 1 se traduit par un déphasage global de 0° nécessaire au maintien des oscillations des résonateurs dans l'oscillateur. Il est également envisageable de réaliser un oscillateur comportant un multiple de quatre sous-ensembles 1 de manière à obtenir un déphasage global de 0°. La première série de sous-ensembles peut donc contenir, à titre d'exemple, quatre, huit, douze, seize ou plus de sous-ensembles.

L'excitation de chaque nanofil 4 est réalisée indépendamment par des moyens d'excitation 5 de type capacitif ou magnétique voire éventuellement thermique. Dans le cas d'une excitation capacitive, la force électrostatique des moyens d'excitation 5 est obtenue au moyen de la différence de potentiel qui existe entre la tension d'alimentation VDC appliquée au nanofil 4 (une tension continue) et la tension de sortie des moyens de détection du sous-ensemble 1 précédent (une tension alternative). La tension de sortie des moyens de détection du sous-ensemble 1 précédent est appliquée sur une électrode des moyens d'excitation. Une utilisation de moyens d'excitation magnétiques a été décrite par Feng et al. « Very High Frequency Silicon Nanowire Electromechanical Resonators » Nano Letters 2007, Vol. 7, N° 7. pp1953-1957.

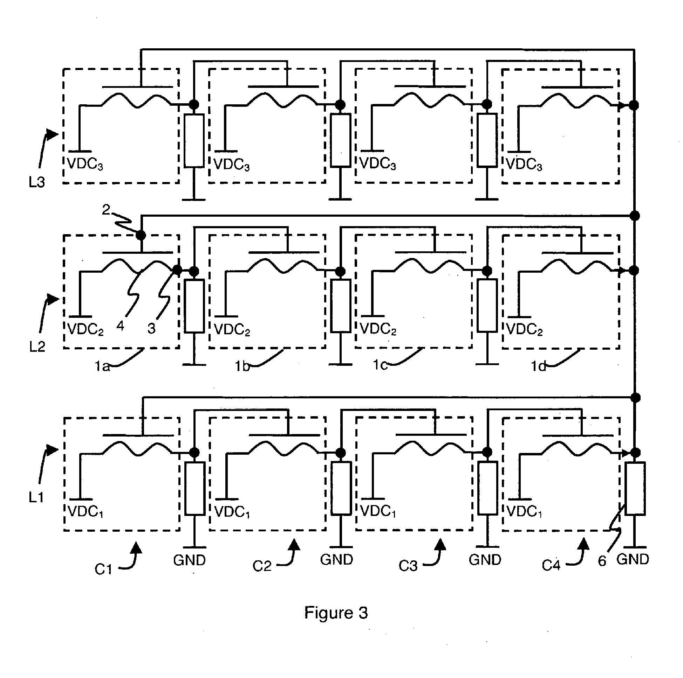

Si le gain de la transduction piézorésistive réalisée par les nanofils 4 est insuffisant, il est avantageux d'utiliser au moins une série additionnelle de quatre sous-ensembles 1 (figures 2 et 3). Ces sous-ensembles sont identiques, dans leur construction, à ceux de la première série. Dans la série additionnelle, les nanofils sont connectés à une tension d'alimentation additionnelle VDCn spécifique.

Dans un mode de réalisation particulier, la tension d'alimentation additionnelle VDCn est identique à la première tension d'alimentation VDC₁.

L'utilisation d'au moins une série additionnelle de quatre sous-ensembles 1 permet d'augmenter le gain en transduction afin de satisfaire à la condition globale d'oscillation des résonateurs 4.

Dans une utilisation particulière, l'ajustement de la tension d'alimentation VDC des différentes séries de sous-ensembles permet d'obtenir un oscillateur contrôlé en tension.

Dans une première variante de réalisation, illustrée à la figure 2, une pluralité de séries additionnelles comportant chacune quatre sous-ensembles 1 est intégrée à l'oscillateur. Dans cette variante de réalisation, un sous-ensemble 1 de chaque série additionnelle est connecté en parallèle aux bornes d'excitation 2 et de sortie 3 d'un sous-ensemble 1 correspondant de la première série. Il en résulte que l'oscillateur comporte quatre colonnes (Ca, Cb, Cc et Cd) de sous-ensembles 1 et que toutes les colonnes présentent le même nombre de sous-ensembles 1. Ainsi, schématiquement, toutes les bornes d'excitation 2 des sous-ensembles d'une même colonne sont connectées à un même point électrique car elles reçoivent toutes le même signal, c'est-à-dire le même potentiel. Il en va de même de toutes les bornes de sortie 3 des sous-ensembles 1 d'une même colonne. En effet, les courants débités par les nanofils d'une même colonne créent aux bornes du circuit résistif 6 associé à cette colonne, une tension qui est représentative de la somme des courants débités. Cette tension de sortie est alors appliquée à tous les moyens d'excitation 5 de la colonne suivante. Dans le mode de réalisation particulier de la figure 2, seules trois séries de sous-ensembles sont illustrées, chaque série ayant sa propre tension d'alimentation VDC₁, VDC₂, VDC₃. Chaque série est représentée sur la figure 2 par une ligne (L1, L2 et L3) de sous-ensembles qui comporte en plus sa propre tension d'alimentation.

Dans une seconde variante de réalisation, illustrée à la figure 3, une pluralité de séries additionnelles comportant chacune quatre sous-ensembles 1a, 1b, 1c et 1d est également intégrée à l'oscillateur. Dans chaque série additionnelle, la connexion des sous-ensembles 1 entre eux est sensiblement identique à celle de la première série. La borne de sortie 3 de trois sous-ensembles consécutifs est connectée à la masse GND par l'intermédiaire d'un circuit résistif 6 correspondant. Chaque série est représentée sur la figure 3 par une ligne (L1, L2 et L3) de sous-ensembles qui comporte en plus sa propre tension d'alimentation.

Ainsi, la borne de sortie 3 d'un des sous-ensembles étant connectée à la borne de sortie de l'oscillateur, les bornes de sortie 3 des sous-ensembles de la série additionnelles qui ne sont pas connectées à la sortie de l'oscillateur sont connectées à la masse GND par l'intermédiaire d'un circuit résistif 6 correspondant. Dans l'exemple illustré à la figure 3, les premier, second et troisième sous-ensembles 1 sont connectés à la masse par l'intermédiaire de leur borne de sortie 3 et d'un circuit résistif 6 tandis que la borne de sortie 3 du quatrième sous-ensemble 1d est directement connectée à la borne de sortie 3 du quatrième sous-ensemble de la première série. Comme dans le mode de réalisation précédent, la figure 3 n'illustre qu'une réalisation particulière comportant trois séries de sous-ensembles ayant leur propre tension d'alimentation VDCn.

Dans ce mode de réalisation, comme dans le précédent, la tension aux bornes du circuit résistif 6 associé à la borne de sortie de l'oscillateur est représentative de la somme des courant débités par la pluralité de séries de sous-ensembles (la première série et les séries additionnelles). Le gain de transduction des nanofils est donc multiplié par le nombre de séries de sous-ensembles intégrées dans l'oscillateur.

Il est avantageux d'utiliser la première variante de réalisation en lieu et place de la seconde variante car la première variante utilise moins de circuits résistifs ce qui permet de réduire la surface utilisée.

Les nanofils 4 qui constituent les résonateurs et les moyens de détection peuvent présenter une section carrée, rectangulaire ou circulaire. Les dimensions du nanofil dans cette section sont typiquement inférieures à 100nm, par exemple entre 10 et 40nm. A titre d'exemple, si le diamètre du nanofil est égal à 10nm et que la longueur est égale à 1,15µm, la fréquence de résonance doit être égale à 50MHz. Si sa longueur est égale à 600nm, la fréquence de résonance est alors égale à 200MHz. Si le nanofil a une section carrée, une épaisseur égale à 20nm et une longueur égale à 1,30µm, la fréquence de résonance est égale à 100MHz. Si l'épaisseur est égale à 40nm et la longueur est égale à 1,90µm la fréquence de résonance est égale à 100MHz.

Avantageusement, la résistance équivalente du circuit résistif 6 est choisie égale à la résistance statique du nanofil 4 avec lequel elle est associée. Dans un mode de réalisation particulier, le circuit résistif 6 est constitué par une résistance et dans un mode de réalisation encore plus particulier, la résistance constituant le circuit résistif est réalisée par un nanofil identique à celui du sous-ensemble associé mais qui n'est pas libéré de son substrat de support afin d'empêcher son oscillation, le nanofil est dit fixe. Le circuit résistif 6 peut être également un transistor qui est utilisé comme une résistance.

Il est également possible d'ajuster la valeur de la résistance équivalente du circuit résistif afin de diminuer les fuites du courant issu des nanofils ce qui a également pour effet de modifier la valeur du gain lié à la transduction par les nanofils.

Les nanofils sont réalisés dans des matériaux électriquement conducteurs, par exemple dans des matériaux semi-conducteurs tels que le silicium, le germanium ou les alliages de silicium-germanium. Pour des nanofils en matériau semi-conducteur, il est nécessaire de réaliser un dopage. Typiquement, pour un nanofil en silicium, un dopage égale à 10¹⁹cm⁻³ (avec du bore) permet d'obtenir un gain de transduction supérieur à l'unité. Si un niveau de dopage plus faible est utilisé, la résistance statique du nanofil augmentant, il peut être nécessaire de prévoir des séries additionnelles de sous-ensembles.

A titre d'exemple, pour un dopage de nanofils en silicium de l'ordre de 10¹⁷cm⁻³ (avec du bore), il est nécessaire d'utiliser environ dix séries additionnelles de sous-ensembles. Pour un dopage de l'ordre de 10¹⁶cm⁻³, une centaine de séries additionnelles peuvent être nécessaires.

Dans le mode de réalisation illustré à la figure 2, lorsque plusieurs séries de sous-ensembles 1 sont intégrées dans un même oscillateur, les différents moyens d'excitation 5 d'une même colonne reçoivent tous le même signal. Ils actionnent tous les nanofils 4 de la même manière. Comme illustré aux figures 4 et 5, il est avantageux de placer les nanofils selon un réseau bidimensionnel ou tridimensionnel et d'utiliser un moyen d'excitation 5 commun à tous les nanofils 4 d'une même colonne. Les nanofils d'une même colonne peuvent alors être adressés collectivement, par exemple, au moyen d'une série de pistes métalliques ou de zones dopées en surface ou encore par un réseau d'interconnexions métalliques tridimensionnelles. Dans ce cas de figure, les bornes d'excitation 2 et de sortie 3 des différents sous-ensembles 1 d'une même colonne sont physiquement confondues car à chaque nanofil est associé un sous-ensemble.

A titre d'exemple, le nanofil ou les nanofils d'une même colonne sont formés sur un substrat de type SOI et reposent, par exemple, sur l'oxyde enterré. Les nanofils sont, par exemple, formés par photolithographie et gravure ou alors par dépôt chimique en phase vapeur. L'oxyde enterré est ensuite éliminé de manière contrôlée sous une partie des nanofils afin de rendre possible leur mouvement. Les nanofils sont alors suspendus au-dessus du substrat situé sous l'oxyde enterré et l'application d'un potentiel variable entre le nanofil et le substrat permet aux moyens d'excitation d'appliquer des forces électrostatiques capables de faire résonner le nanofil.

Ainsi, dans chaque sous-ensemble, les moyens d'excitation 5 comportent au moins une électrode qui est disposée en regard du ou des nanofils. L'électrode ou les électrodes sont alors connectées à la borne d'excitation des moyens d'excitation du sous-ensemble.

Dans l'oscillateur, il n'y a pas de boucle de réaction constituée par un circuit électronique ce qui permet la réalisation d'un oscillateur purement électromécanique extrêmement compact. Le seul apport d'énergie dans l'oscillateur est effectué par la tension d'alimentation VDC qui est une tension continue appliquée sur chaque nanofil. La tension d'alimentation VDC permet de contrôler l'amplitude des oscillations des nanofils.

## Revendications

1. Oscillateur comportant au moins un résonateur électromécanique (4), des moyens d'excitation (5) du résonateur et des moyens de détection du mouvement du résonateur, oscillateur **caractérisé en ce qu'**il comporte au moins une première série d'un multiple de quatre sous-ensembles (1) comportant chacun une borne d'excitation (2) et une borne de sortie (3), les sous-ensembles (1) étant montés en série en boucle fermée, la borne de sortie (3) de chaque sous-ensemble (1) étant connectée à la borne d'excitation (2) du sous-ensemble (1) suivant, l'oscillateur comportant une borne de sortie constituée par une borne de sortie (3) d'un des sous-ensembles (1), chaque sous-ensemble (1) comportant les moyens d'excitation (5) et au moins un nanofil constituant le résonateur électromécanique (4), une première borne du nanofil (4) étant connectée à une première tension d'alimentation (VDC₁), une seconde borne du nanofil (4) constituant la borne de sortie (3), une borne d'entrée des moyens d'excitation (5) constituant la borne d'excitation (2) du sous-ensemble, la borne de sortie (3) de chaque sous-ensemble (1) est connectée à la masse (GND) par l'intermédiaire d'un circuit résistif (6) correspondant.

2. Oscillateur selon la revendication 1, **caractérisé en ce que** le nanofil (4) constitue les moyens de détection du mouvement, les moyens de détection étant de type piézorésistif.

3. Oscillateur selon l'une des revendications 1 et 2, **caractérisé en ce que** chaque sous-ensemble (1) comporte une pluralité de nanofils (4) connectés en parallèles entre la première tension d'alimentation (VDC1) et la borne de sortie (3) du sous-ensemble (1).

4. Oscillateur selon l'une quelconque des revendications 1 à 3, **caractérisé en ce que** le circuit résistif (6) est une résistance.

5. Oscillateur selon l'une quelconque des revendications 1 à 4, **caractérisé en ce qu'**il comporte au moins une série additionnelle de quatre sous-ensembles (1), le nanofil (4) de chaque sous-ensemble (1) de la série additionnelle étant connecté à une tension d'alimentation additionnelle (VDCn), un sous-ensemble (1) de la série additionnelle étant connecté en parallèle aux bornes d'excitation (2) et de sortie (3) d'un sous-ensemble (1) correspondant de la première série.

6. Oscillateur selon l'une quelconque des revendications 1 à 4, **caractérisé en ce qu'**il comporte au moins une série additionnelle de quatre sous-ensembles (1), le nanofil (4) de chaque sous-ensemble (1) de la série additionnelle étant connecté à une tension d'alimentation additionnelle (VDCn), la borne de sortie (3) de chaque sous-ensemble (1) de la série additionnelle étant connectée à la borne d'excitation (2) du sous-ensemble (1) suivant, la borne de sortie (3) d'un des sous-ensembles (1) étant connectée à la borne de sortie de l'oscillateur, la borne de sortie (3) des sous-ensembles (1) de la série additionnelle non connectée à la borne de sortie (3) de l'oscillateur étant connectée à la masse (GND) par l'intermédiaire d'un circuit résistif (6) correspondant.

7. Oscillateur selon l'une quelconque des revendications 1 à 6, **caractérisé en ce que** le circuit résistif (6) est constitué par au moins un nanofil fixe.

8. Oscillateur selon l'une quelconque des revendications 1 à 7, **caractérisé en ce que** les moyens d'excitation de chaque sous-ensemble comportent au moins une électrode en regard du ou des nanofils, chaque électrode étant reliée à la borne d'excitation (2) desdits moyens.

## Patentansprüche

1. Oszillator, umfassend wenigstens einen elektromechanischen Resonator (4), Mittel zur Erregung (5) des Resonators sowie Mittel zur Erfassung der Bewegung des Resonators, Oszillator, der **dadurch gekennzeichnet ist, dass** er wenigstens eine erste Reihe von einem Vielfachen von vier Untereinheiten (1) umfasst, die jeweils einen Erregeranschluss (2) und einen Ausgangsanschluss (3) umfassen, wobei die Untereinheiten (1) in geschlossener Schleife in Reihe geschaltet sind, wobei der Ausgangsanschluss (3) einer jeden Untereinheit (1) an den Erregeranschluss (2) der folgenden Untereinheit (1) angeschlossen ist, wobei der Oszillator einen Ausgangsanschluss, der durch einen Ausgangsanschluss (3) von einer der Untereinheiten (1) gebildet ist, umfasst, wobei jede Untereinheit (1) die Erregungsmittel (5) und wenigstens einen den elektromechanischen Resonator (4) bildenden Nanodraht umfasst, wobei ein erster Anschluss des Nanodrahtes (4) an eine erste Speisespannung (VDC1) angeschlossen ist, wobei ein zweiter Anschluss des Nanodrahtes (4) den Ausgangsanschluss (3) bildet, wobei ein Eingangsanschluss der Erregungsmittel (5) den Erregeranschluss (2) der Untereinheit bildet, wobei der Ausgangsanschluss (3) einer jeden Untereinheit (1) mittels einer entsprechenden Widerstandsschaltung (6) an die Masse (GND) angeschlossen ist.

2. Oszillator nach Anspruch 1, **dadurch gekennzeichnet, dass** der Nanodraht (4) die Mittel zur Erfassung der Bewegung bildet, wobei die Erfassungsmittel vom piezoresistiven Typ sind.

3. Oszillator nach einem der Ansprüche 1 und 2, **dadurch gekennzeichnet, dass** jede Untereinheit (1) eine Vielzahl von Nanodrähten (4) umfasst, die zwischen der ersten Speisespannung (VDC1) und dem Ausgangsanschluss (3) der Untereinheit (1) parallel geschaltet sind.

4. Oszillator nach einem der Ansprüche 1 bis 3, **dadurch gekennzeichnet, dass** die Widerstandsschaltung (6) ein Widerstand ist.

5. Oszillator nach einem der Ansprüche 1 bis 4, **dadurch gekennzeichnet, dass** er wenigstens eine zusätzliche Reihe von vier Untereinheiten (1) umfasst, wobei der Nanodraht (4) einer jeden Untereinheit (1) der zusätzlichen Reihe an eine zusätzliche Speisespannung (VDCn) angeschlossen ist, wobei eine Untereinheit (1) der zusätzlichen Reihe zu den Erreger- (2) und Ausgangsanschlüssen (3) einer entsprechenden Untereinheit (1) der ersten Reihe parallel geschaltet ist.

6. Oszillator nach einem der Ansprüche 1 bis 4, **dadurch gekennzeichnet, dass** er wenigstens eine zusätzliche Reihe von vier Untereinheiten (1) umfasst, wobei der Nanodraht (4) einer jeden Untereinheit (1) der zusätzlichen Reihe an eine zusätzliche Speisespannung (VDCn) angeschlossen ist, wobei der Ausgangsanschluss (3) einer jeden Untereinheit (1) der zusätzlichen Reihe an den Erregeranschluss (2) der folgenden Untereinheit (1) angeschlossen ist, wobei der Ausgangsanschluss (3) von einer der Untereinheiten (1) an den Ausgangsanschluss des Oszillators angeschlossen ist, wobei der Ausgangsanschluss (3) der Untereinheiten (1) der zusätzlichen Reihe, der nicht an den Ausgangsanschluss (3) des Oszillators angeschlossen ist, mittels einer entsprechenden Widerstandsschaltung (6) an die Masse (GND) angeschlossen ist.

7. Oszillator nach einem der Ansprüche 1 bis 6, **dadurch gekennzeichnet, dass** die Widerstandsschaltung (6) durch wenigstens einen festen Nanodraht gebildet ist.

8. Oszillator nach einem der Ansprüche 1 bis 7, **dadurch gekennzeichnet, dass** die Erregungsmittel einer jeden Untereinheit wenigstens eine Elektrode gegenüber dem oder den Nanodrähten umfassen, wobei jede Elektrode mit dem Erregeranschluss (2) der Mittel verbunden ist.

## Claims

1. Oscillator comprising at least an electromechanical resonator (4), excitation means (5) of the resonator and detection means of movement of the resonator, oscillator **characterized in that** it comprises at least a first series of a multiple of four sub-assemblies (1) each comprising an excitation terminal (2) and an output terminal (3), the sub-assemblies (1) being connected in series in a closed loop, the output terminal (3) of each sub-assembly (1) being connected to the excitation terminal (2) of the following sub-assembly (1), the oscillator comprising an output terminal formed by an output terminal (3) of one of the sub-assemblies (1), each sub-assembly (1) comprising the excitation means (5) and at least one nanowire constituting the electromechanical resonator (4), a first terminal of the nanowire (4) being connected to a first supply voltage (VDC₁), a second terminal of the nanowire (4) constituting the output terminal (3), and an input terminal of the excitation means (5) constituting the excitation terminal (2) of the sub-assembly, the output terminal (3) of each sub-assembly (1) is connected to ground (GND) by means of a corresponding resistive circuit (6).

2. Oscillator according to claim 1, **characterized in that** the nanowire (4) constitutes the movement detection means, the detection means being of piezoresistive type.

3. Oscillator according to one of claims 1 and 2, **characterized in that** each sub-assembly (1) comprises a plurality of nanowires (4) connected in parallel between the first supply voltage (VDC1) and the output terminal (3) of the sub assembly (1).

4. Oscillator according to any one of claims 1 to 3, **characterized in that** the resistive circuit (6) is a resistance.

5. Oscilfator according to any one of claims 1 to 4, **characterized in that** it comprises at least one additional series of four sub-assemblies (1), the nanowire (4) of each sub-assembly (1) of the additional series being connected to an additional supply voltage (VDCn), a sub-assembly (1) of the additional series being connected in parallel to the excitation terminal (2) and output terminal (3) of a corresponding sub-assembly (1) of the first series.

6. Oscillator according to any one of claims 1 to 4, **characterized in that** it comprises at least one additional series of four sub-assemblies (1), the nanowire (4) of each sub-assembly (1) of the additional series being connected to an additional supply voltage (VDCn), the output terminal (3) of each sub-assembly (1) of the additional series being connected to the excitation terminal (2) of the following sub-assembly (1), the output terminal (3) of one of the sub-assemblies (1) being connected to the output terminal of the oscillator, the output terminal (3) of the sub-assemblies (1) of the additional series that is not connected to the output terminal (3) of the oscillator being connected to ground (GND) by means of a corresponding resistive circuit (6).

7. Oscillator according to any one of claims 1 to 6, **characterized in that** the resistive circuit (6) is formed by at least one fixed nanowire.

8. Oscillator according to any one of claims 1 to 7, **characterized in that** the excitation means of each sub-assembly comprise at least one electrode facing the nanowire or nanowires, each electrode being connected to the excitation terminal (2) of said means.
